# EUROPÄISCHE PATENTSCHRIFT

(11) **EP 1 156 131 B1**
(45) Veröffentlichungstag und Bekanntmachung des Hinweises auf die Patenterteilung: **27.01.2010**
(21) Anmeldenummer: 01111533.4
(22) Anmeldetag: 11.05.2001
(51) Int. Cl.: C23C 14/02, C23C 16/02

(54) **Verfahren zur Herstellung beschichteter Kunststoffkörper sowie Verwendung desselben**
Process for making coated plastic parts and its application
Procédé de production de corps en matière plastique revêtus et application dudit procédé

(30) Priorität: 17.05.2000 CH 9832000
(43) Veröffentlichungstag der Anmeldung: 21.11.2001
(73) Patentinhaber: Oerlikon Trading AG, Trübbach, 9477 Trübbach (CH)
(72) Erfinder: Beck, Eugen, 9497 Triesenberg (LI); Ramm, Jürgen, 9475 Sevelen (CH); Zimmermann, Heinrich, 9470 Werdenberg (CH)
(74) Vertreter: Troesch Scheidegger Werner AG

(56) Entgegenhaltungen:
- US-A- 4 886 681
- VALLON S ET AL: "IMPROVEMENT OF THE ADHESION OF SILICA LAYERS TO POLYPROPYLENE INDUCED BY NITROGEN PLASMA TREATMENT" THIN SOLID FILMS,CH,ELSEVIER-SEQUOIA S.A. LAUSANNE, Bd. 290/291, 15. Dezember 1996 (1996-12-15), Seiten 68-73, XP000693808 ISSN: 0040-6090
- KORNER N ET AL: "HYDROGEN PLASMA CHEMICAL CLEANING OF METALLIC SUBSTRATES AND SILICON WAFERS" SURFACE AND COATINGS TECHNOLOGY,NL,AMSTERDAM, Bd. 76/77, Nr. PART 01, 24. April 1995 (1995-04-24), Seiten 731-737, XP002056342
- CUOMO J ET AL.: "SUBSTRATE-CLEANING BY LOW-ENERGY BOMBARDMENT" IBM TECHNICAL DISCLOSURE BULLETIN, Bd. 10, Nr. 4, September 1967 (1967-09), Seiten 352-353, XP002146024 NEW YORK US

## Beschreibung

Die vorliegende Erfindung betrifft ein Verfahren zur Herstellung beschichteter Kunststoffkörper, bei dem, vor der Beschichtung, die zu beschichtende Oberfläche einer Vorbehandlung in einer angeregten Gasatmosphäre unterworfen wird.

Die vorliegende Erfindung geht dabei von der Einsicht aus, dass bei der Herstellung beschichteter Kunststoffkörper das Kunststoffmaterial, das Beschichtungsmaterial sowie das Beschichtungsverfahren die zusätzlichen spezifischen Vorkehrungen zur Erlangung zufriedenstellender Beschichtungshaftung an der Kunststoffoberfläche bestimmen. Damit ergibt sich eine überaus grosse Vielfalt unterschiedlicher zusätzlicher Vorkehrungen, die getroffen werden müssen, um, jeweils spezifisch, die Haftung einer bestimmten Beschichtung auf einem Kunststoffkörper bestimmten Materials sicherzustellen.

In diesem Sinne sollen die nachfolgenden Erläuterungen lediglich Beispiele und entsprechende bekannte Lösungsansätze aufzeigen.

Aus dem Vortrag von G. Legeay, "Surface Modification of natural or synthetic polymers by cold plasmas", gehalten an der 2. Conf. Plasma Chem. Tech. 1984, ist es bekannt, die Haftung einer Metallbeschichtung an Kunststoffoberflächen mit Hilfe einer vorgängigen Plasmabehandlung der Oberfläche zu erhöhen. Für die Plasmabehandlung werden beispielsweise sauerstoff-, helium- und kohlenstoffhaltige Gase verwendet.

Die Verwendung von Helium- oder Sauerstoff-Plasmaentladungen zur Behandlung von Kunststoffoberflächen ist auch bekannt aus dem Fachaufsatz von J. Hall aus J. Appl. Polym. Sci. Vol. 13, 1969. Die hier erläuterte Plasmabehandlung hat zum Ziel, eine verbesserte Verklebbarkeit von Kunststoffen zu erreichen.

Die Verwendung von Ar-N₂. Plasmaentladungen zur Verbesserung der Haftung von Silica schichten auf Polypropylen ist aus dem Fachaufsatz von S. Vallon aus Thin Solid Films. 290-291, (1996), Elsevier Science SA, Lausanne, bekannt.

Im Fachaufsatz von J. Hollahan aus J. Appl. Polym. Sci. Vol. 13, 1969 ist es bekannt, Kunststoffe einer Plasmabehandlung auszusetzen mit ammoniak-, stickstoff- und wasserstoffhaltigem Gas. Dies zur Verbesserung der Oberflächenhaftung und der Benetzbarkeit. Eingesetzt wird bei dieser Anwendung eine Hochfrequenzplasmaentladung. In der US 4 957 603 wird auf die Schwierigkeiten eingegangen, welche sich bei der Beschichtung optischer Speicherplatten aus PMMA ergeben. Dieser Kunststoff sei besonders schwierig zu beschichten, bei Verwendung eines Kathodenzerstäubungsverfahrens. Ein weiteres bekanntes Verfahren zur Erhöhung der Haftfestigkeit einer Beschichtung auf Kunststoffoberflächen ist das Zwischenbeschichten mit Oxiden oder Nitriden.

Für das Metallbeschichten insbesondere eines PMMA-Kunststoffkörpers durch Magnetron-Kathodenzerstäuben schlägt die EP 0 507 113 vor, die Beschichtung in einer plasmaangeregten Gasatmosphäre aus Argon und mindestens einem weiteren Edelgas vorzunehmen und dabei während des Beschichtungsvorganges das Mischungsverhältnis der Gasatmosphäre gesteuert zu verändern.

Die DE 197 52 889 schlägt vor, auf optischen Bauelementen, wie beispielsweise Monitorsichtfenstern, Flat Panel Displays-Kathodenstrahlröhren, die Abriebfestigkeit von aufgebrachten Indium-Zinn-Oxid(ITO)-Schichten dadurch zu verbessern, dass während des Beschichtungsvorganges die zu beschichtende Oberfläche mit Argon-Ionen mit einer Energie von 60 eV bis 90 eV beschossen wird. Bei der Beschichtung organischer Oberflächen, wie beispielsweise von Polymethylmethacrylat (PMMA), wird vor der Beschichtung an der Oberfläche eine Plasmabehandlung in Vakuum unter Zufuhr von reaktivem Sauerstoff und von Wasser enthaltendem Gas vorgenommen.

Aus der CH 688 042 ist es bekannt, eine Kunststoffoberfläche durch magnetfeldunterstütztes Zerstäuben in einer Gasatmosphäre aus argon- und kohlenstoffhaltigem Gas vorzunehmen.

Im weiteren ergeben sich beim Sputterbeschichten von PMMA-Oberflächen, im Unterschied zur Beschichtung von Polykarbonat-Oberflächen, beim Targetwechsel, d.h. bei Einsatz eines neuen Targets oder bei längerem Öffnen der Prozesskammer gegen Umgebungsatmosphäre, dadurch Probleme, dass die Sputterfläche des Targets durch eine Oxidschicht bedeckt ist. Zum Wegsputtern dieser Oxidschicht ist in der Anfahrphase ein besseres Vakuum erforderlich als bei eingefahrenem Beschichtungsprozess. Das starke Ausgasen des PMMA, im Vergleich beispielsweise zu Polykarbonat, verschlechtert die Vakuumbedingungen derart, dass ein Wechsel vom sogenannten Oxidmode in den metallischen Mode verunmöglicht ist. Das Problem kann gelöst werden, indem zum Vorsputtern, d.h. zum Anfahren des Prozesses, Argon als Sputtergas verwendet wird sowie Polykarbonatscheiben als Dummy-Substrate eingesetzt werden. Dies verkompliziert und verlängert die Anfahrprozedur erheblich. Dass Aluminiumschichten an Polykarbonat-Oberflächen schlecht haften, wird von Warner Advanced Media Operation bewusst genutzt, nämlich zur Herstellung von DVD14- bzw. DVD18-Disks.

Es ist nun Aufgabe der vorliegenden Erfindung, ein Verfahren eingangs genannter Art vorzuschlagen, das:
- praktisch als Standard-Verfahren einsetzbar sein soll, in weiten Grenzen unabhängig vom Material der zu beschichtenden Kunststoffoberfläche, von der eingesetzten Beschichtungstechnik sowie vom eingesetzten Beschichtungsmaterial. Es soll insbesondere für die bekanntlich schwierig zu beschichtenden Materialien, wie insbesondere PMMA, aber auch für weniger kritische Kunststoffmaterialien, wie Polykarbonat, bismaleimide triazine-(BT)-Harze, brandhemmende Epoxy-Glas-Laminate, insbesondere FR4 sowie für Oberflächen, die mit Photound/oder Löt-Lacken zu beschichten sind sowie ähnliche Materialien der Halbleiterindustrie sowie auch für Leiterplattenmaterialien gleichermassen gute Haftfestigkeit der aufgebrachten Beschichtung sicherstellen,
- die oben erwähnten Probleme bei Sputterbeschichten von PMMA und ähnlichen Materialien löst.

Diese Aufgabe wird erfindungsgemäss dadurch gelöst, dass die Gasatmosphäre überwiegend aus Argon und Stickstoff und/oder Wasserstoff gebildet wird und die Ionenenergie in der Gasatmosphäre und im Bereich der zu beschichtenden Oberfläche höchstens 50 eV ist. Bevorzugterweise wird die Ionenenergie dabei höchstens zu 20 eV, vorzugsweise höchstens zu 10 eV gewählt.

Erstaunlicherweise werden durch die Kombination der erwähnten Gasatmosphäre und der erwähnten tiefen Ionenergien die obgenannten Teilaufgaben kombiniert gelöst. Wird beispielsweise anstelle von Wasserstoff und/oder Stickstoff Sauerstoff eingesetzt, so lässt sich diese Wirkung nicht erzielen, gleichgültig, ob die Bedingung bezüglich Ionenenergie erfüllt ist oder nicht. Auch zeigt sich diese Wirkung bei einem Wasserstoffund/oder Stickstoffplasma nicht, bei dem höhere Ionenenergien auftreten, wie dies üblicherweise bei Plasmaanregung mit Hf der Fall ist.

Es wird mithin erfindungsgemäss für die Vorbehandlung der zu beschichtenden Kunststoffoberflächen ein niederenergetisches Argon/Stickstoff- und/oder Wasserstoff-Plasma eingesetzt.

Die Anregung der Gasatmosphäre erfolgt dabei bevorzugterweise mittels einer Plasmaentladung oder mittels UV-Strahlung. Niederenergetische Plasmen, welche sich primär für den Einsatz im Rahmen vorliegender Erfindung eignen, sind Mikrowellen- oder ECR-Entladungen, vorzugsweise aber Niederspannungsentladungen. Auch Hf- oder getaktete DC-Plasmaentladungen können eingesetzt werden, sofern die Druckverhältnisse entsprechend gewählt werden und/oder die Entladung soweit von der vorzubehandelnden Kunststoffoberfläche entfernt unterhalten wird, dass die erwähnten Niederenergie-Bedingungen an der erwähnten Oberfläche erfüllt sind. Bevorzugt wird, wie erwähnt, eine Niederspannungsentladung eingesetzt, vorzugsweise mit Elektronenemittierender Heisskathode oder die Gasanregung mittels UV-Strahlung mit H- und N-Linien.

Als Edelgas wird bevorzugterweise Argon eingesetzt.

Erstaunlicherweise hat sich nun bei der Realisation des erfindungsgemässen Fertigungsverfahrens gezeigt, dass sich nicht nur wesentliche Vorteile bezüglich Haftfestigkeit der nachmals aufgebrachten Beschichtung und bezüglich Prozessführung beim Sputterbeschichten von PMMA-Oberflächen oder von Oberflächen ähnlich kritischer Kunststoffe ergeben, sondern dass durch die erwähnte erfindungsgemässe Vorbehandlung das Fertigungsverfahren unter Einbezug einer Lagerungszeit der vorbehandelten Kunststoffoberflächen an Normalatmosphäre ohne weiteres durchgeführt werden kann: Die im Rahmen des erfindungsgemässen Verfahrens vorbehandelten Oberflächen werden passiviert, ohne dass diese Passivierung nachmals für die Weiterbehandlung, nämlich für die Beschichtung, spezielle Massnahmen erforderte, um rückgängig gemacht zu werden.

In bevorzugter Ausführungsform des erfindungsgemässen Verfahrens wird die Beschichtung durch einen Vakuumbeschichtungsprozess vorgenommen. Dabei wird bevorzugt Plasmapolymerisation, ein reaktives oder nicht reaktives PVD-Verfahren oder ein PECVD-Verfahren eingesetzt.

Insbesondere bevorzugt erfolgt die Beschichtung durch Plasmapolymerisation oder durch reaktives oder nicht reaktives Sputtern, dabei bevorzugt Magnetronsputtern oder durch reaktives oder nicht reaktives Aufdampfen, sei dies durch Elektronenstrahl-Bedampfen, durch Bedampfen aus beheiztem Tiegel oder durch Funkenverdampfen. Im weiteren wird das erfindungsgemässe Verfahren insbesondere an den vorerwähnten kritischen Kunststoffen eingesetzt, nämlich an PMMA-Oberflachen oder Oberflächen aus BT oder FR4.

Im weiteren wird bevorzugterweise der Kunststoffkörper mit einem Metall oder einer Metallverbindung beschichtet, wie beispielsweise mit einem Nitrid, Oxid, Karbid oder deren Mischformen.

Das erfindungsgemässe Fertigungsverfahren wird insbesondere bevorzugt für die Herstellung optischer Speicherplatten, für die Herstellung optischer Bauelemente, für Leiterplatten oder für Bauteile im Rahmen der Halbleiterfertigung eingesetzt.

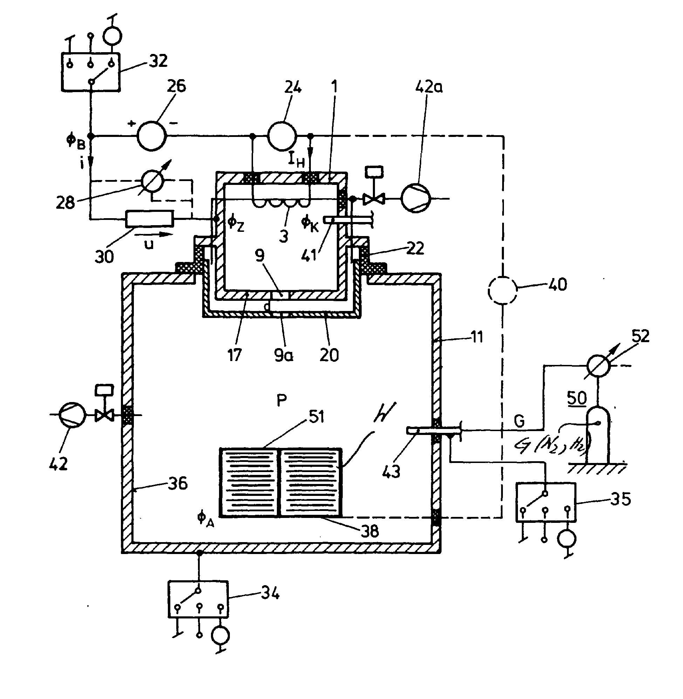

Die Erfindung wird anschliessend beispielsweise anhand einer Figur sowie von Beispielen erläutert. Die einzige Figur zeigt beispielsweise eine Anlagenkonfiguration zur Durchführung mindestens des Vorbehandlungsschrittes im Rahmen des erfindungsgemässen Herstellungsverfahrens.

In einer Kathodenkammer 1 ist eine thermionische Kathode 3 isoliert montiert. Partien 17 der Kathodenkammer 1 umranden eine Blendenöffnung 9. Die Kathodenkammer 1 ist über Isolationsträger 22 an der Wand der Behandlungskammer 11 montiert. Es umschliesst ein Schirm 20, der sowohl bezüglich Kathodenkammer 1 wie auch bezüglich Behandlungskammer 11 potentialschwebend betrieben wird, die Partien 17 auf Dunkelraumabstand d bis unmittelbar in den Bereich der Blendenöffnung 9. Die thermionische Kathode wird mittels einer Quelle 24 mit dem Heizstrom I_{H} betrieben und ist über eine Spannungsquelle 26 und, generell gesprochen, eine Einheit 28 auf mindestens einen Teil der Kathodenkammerwand geführt, bevorzugterweise auf die Kathodenkammerwand selber. Die Einheit 28 wirkt als Strombegrenzung und bewirkt in Funktion des sie durchfliessenden Stromes i einen Spannungsabfall u. Sie kann, wie gestrichelt dargestellt, durch eine stromgesteuerte Spannungsquelle realisiert sein, wird aber bevorzugterweise durch ein passives Schaltelement, dabei insbesondere durch ein Widerstandselement 30, realisiert.

Der positive Pol der Spannungsquelle 26 kann auf ein Bezugspotential, sei dies Masse, oder ein weiteres vorgegebenes Potential gelegt werden oder kann potentialfrei betrieben werden, wie dies rein schematisch durch den Möglichkeitsumschalter 32 dargestellt ist. Desgleichen kann, da von der Kathodenkammer 1 elektrisch isoliert, die Behandlungskammer 11, wie mit dem Möglichkeitsumschalter 34 rein schematisch dargestellt, auf Massepotential, auf einem Bezugspotential oder gegebenenfalls sogar potentialschwebend betrieben werden. Die Behandlungskammer-Innenwand 36 oder mindestens Partien davon können bezüglich der thermionischen Kathode 3 als Anode geschaltet sein; bevorzugterweise wird aber eine separate Anode 38, wie gestrichelt dargestellt, vorgesehen, welche über eine Spannungsquelle 40 mit Bezug auf die thermionische Kathode 3 anodisch, d.h. positiv, beschaltet wird. Die Anode 38 wird dabei bevorzugterweise als Werkstückträger für die schematisch eingetragenen Werkstücke W verwendet. Der Kathodenkammer wird über Gaszuspeiseleitung 41 ein Edelgas als Arbeitsgas, vorzugsweise Argon, zugeführt. Ueber eine weitere, schematisch dargestellte Gaszuspeiseleitung 43, wie mit dem Möglichkeitsschalter 35 schematisch dargestellt, je nach Potentiallegung der Kammer 11 auf Potential legbar, wird das Wasserstoff- und/oder Stickstoff-enthaltende Gas G zugeführt. Das Gas G wird über ein schematisch dargestelltes Ventil 52 eingelassen.

Eine Pumpanordnung 42 ist vorgesehen, um die Kammer 11 und gegebenenfalls die Kathodenkammer 1 abzupumpen, wobei, wie dargestellt, zusätzlich eine Pumpanordnung 42a vorgesehen sein kann, um die Kathodenkammer getrennt abzupumpen. Die Blendenanordnung mit der Blendenöffnung 9 wirkt als Druckstufe zwischen Druck in der Kathodenkammer 1 und Druck in der Behandlungskammer 11.

Es bildet die Wand der Kathodenkammer 1 Zündelektrode: Zum Zünden der Niederspannungsentladung wird die thermionische Kathode 3 zur Elektronenemission mit dem Heizstrom I_{H} aufgeheizt, und es wird Argon in die Kathodenkammer eingelassen. Auf Grund der Abstandsrelation zwischen Wand der Kathodenkammer 1 und der Kathode 3 erfolgt durch Potentiallegung letzterer die Zündung der Entladung, worauf ein Strom i durch die Einheit 28, insbesondere den Widerstand 30, fliesst. Damit reduziert sich das vormals auf Zündwert liegende Potential Φ_{z} der Kathodenkammerwand 17, womit im Betrieb die Wandung der Kammer 1 nur noch in vernachlässigbarem Masse als Anode wirkt und die Primärentladung durch die Blendenanordnung mit der Oeffnung 9 auf die behandlungskammerseitige Anode 38 gezogen wird.

Mit der in der Figur dargestellten Anlage wurden alle nachfolgend beschriebenen, zu beschichtenden Kunststoffkörper wie folgt vorbehandelt:

### Vorbehandlung

- Einlegen der Substrate in die Behandlungskammer.
- Abpumpen der Behandlungskammer auf einen Druck von höchstens 10⁻⁴ mbar.
- Einlassen von Argon bis zu einem Druck im Bereich zwischen 2 x 10⁻⁴ mbar und 5 x 10⁻² mbar, vorzugsweise auf ca. 5 x 10⁻³ mbar.
- Einlassen von Wasserstoff oder Stickstoff oder eines Wasserstoff/Stickstoff-Gemisches, bis zum Erreichen eines Druckes zwischen 3 x 10⁻⁴ mbar und 10⁻¹ mbar, vorzugsweise bis zu einem Totaldruck von ca. 8 x 10⁻³ mbar.
- Einschalten des Heisskathoden-Heizstromes I_{H} bis zum Einsetzen der Elektronenemission.
- Anlegen einer Spannung zwischen Heisskathode 3 und Massepotential, resultierend in einem Entladestrom zwischen 1A und 200A.
- Ionenenergien < 50 eV, z.B. ca. 15 eV, 12 eV.
- 10-min. Plasmabehandlung.
- Belüften der Behandlungskammer.

Vorangegangene Plasmamessungen (Korner, N. et al.) ergaben, dass unter den oben benannten Prozessbedingungen das Plasmapotential nur ca. 2 V vom Massepotential verschieden ist. Die ungefähren Ionenenergien lassen sich aus der Potentialdifferenz zwischen Plasmapotential und Substratpotential ableiten.

### 1. Beispiel: Beschichten von PMMA-Körpern durch Plasmapolymerisation

(- Ionenenergie bei der Vorbehandlung: 15 eV) - Aufenthaltsdauer der vorbehandelten PMMA-Substrate an Normalatmosphäre bis zur Beschichtung: 1 h bis 12 h Anschliessend wurde in einem kapazitiv gekoppelten Hf(13,56 MHz)-Plasmareaktor die Beschichtung mittels Plasmapolymerisation, unter Verwendung von Hexamethyldisiloxan (HMDSO) durchgeführt. Für diese Beschichtung wurden die vorbehandelten Substrate in den Plasmareaktor gebracht, der auf einen Druck 10⁻³ mbar abgepumpt wurde. Anschliessend wurde über einen Gasflussregler 50 sccm HMDSO eingelassen und bei einer Reaktorleistung von 500 W und dem sich einstellenden Druck von 1,2 x 10⁻² mbar, 45 Min. lang Plasmapolymere abgeschieden. Nach Beschichtungsende beträgt die Schichtdicke 2 µm. Die Schicht aus Plasmapolymeren ist farblos und transparent.

### 2. Beispiel: Sputterbeschichten von PMMA-Kunststoffkörpern

| | |
|---|---|
| (Ionenenergie bei der Vorbehandlung: | 12 eV) |
| Aufenthaltsdauer nach der Vorbehandlung an Normalatmosphäre bis zur Beschichtung: | 1 h bis 3 Tage |

Nach der Vorbehandlung wurden einzelne Körper (scheibenförmig) über ein automatisches Handlingsystem in die Schleuse der Beschichtungskammer eingebracht. Die Schleuse wurde auf ca. 1 mbar abgepumpt, danach die Körper von der Schleuse in die Beschichtungskammer (gleiches Vakuum) transferiert. Es erfolgte eine Beschichtung mit Aluminium durch DC-Sputtern bei einer Leistung von ca. 6 kW während 2 Sek. (25 nm/Sek.). Danach wurde der Körper wieder ausgeschleust.

### 3. Beispiel: Beschichtung von Kunststoff-Brillengläsern

Nach der erfindungsgemässen Vorbehandlung (s. oben) wurde eine Anzahl der Brillengläser in eine Batch-Beschichtungsanlage eingebracht. Nach Abpumpen der Beschichtungskammer auf 10⁻⁴ mbar wurde Argon bis zu einem Druck von 5 x 10⁻³ mbar eingelassen. Durch getaktetes DC-Sputtern von einem Siliziumtarget unter Zugabe von Sauerstoff (8 x 10⁻³ mbar) resultierte an den Brillengläsern eine SiOₓ₋Schicht.

### 4. Beispiel: Bedampfungsbeschichten verschiedener Kunststoffsubstrate

Es wurden Substrate aus unterschiedlichen Kunststoffen erfindungsgemäss (s. oben) vorbehandelt.

Danach wurden die Substrate in eine Bedampfungskammer eingeführt, die auf 10⁻⁵ mbar abgepumpt wurde. Unter einer Blende wurde mit Hilfe eines Elektronenstrahlverdampfers Aluminium in einem Tiegel verdampft. Nach Öffnen der Blende erfolgte eine Beschichtung mit einer Beschichtungsrate von 1 nm/Sek. Nach 50 Sek. wurde die Blende geschlossen und der Elektronenstrahlverdampfer stillgesetzt. Nach weiteren 10 Min. wurde die Kammer belüftet und wurden die Substrate entnommen.

### 5. Beispiel: Folienbeschichtung

Es wurden Kunststoffolien erfindungsgemäss (s. oben) (Ionenenergien von ca. 8 eV) vorbehandelt. Anschliessend wurden die Folien mit Si, SiGe bzw. Ge vakuumbeschichtet.

### 6. Beispiel: Kupferschichten auf PMMA-Substraten

PMMA-Substrate wurden erfindungsgemäss (s. oben) vorbehandelt. Dabei wurden unterschiedliche Vorbehandlungs-Prozessparameter eingestellt, nämlich:

| (a) Gasfluss Ar/N₂ | 20/20 sccm |
|---|---|
| Entladestrom | 40 A |
| Plasmabehandlungszeit | 10 Min. |

| (b) Gasfluss Ar/N₂/H₂ | 20/20/10 sccm |
|---|---|
| Entladestrom | 40 A |
| Plasmabehandlungszeit | 10 Min. |

| (c) Gasfluss Ar/H₂ | 20/20 sccm |
|---|---|
| Entladestrom | 40 A |
| Plasmabehandlungszeit | 10 Min. |

In einigen Fällen wurde der Plasmavorbehandlung noch eine Nassreinigung vorgeschaltet, in einem Ultraschallbad mit DI-Wasser.

Die vorbehandelten PMMA-Substrate wurden durch Sputtern mit einer 128 nm dicken bzw. 256 nm dicken Kupferschicht beschichtet.

### Ergebnisse:

In allen Beispielen wurden erfindungsgemäss vorbehandelte, dann beschichtete mit identischen, nicht vorbehandelten, identisch beschichteten Substraten verglichen. Die Haftfestigkeit der jeweiligen Schichten wurde mittels Scotch-Test nach MIL-STD-810A und MIL-M-13508 getestet. Durchwegs ergab sich eine wesentlich bessere Schichthaftung an erfindungsgemäss vorbehandelten Substraten, verglichen mit der Schichthaftung an nicht vorbehandelten Substraten.

Wird gemäss dem erwähnten Scotch-Test der Wert 1.0 definiert dadurch, dass nach dem Abziehen des Klebbandes 100 % der Schicht auf dem Substrat verbleibt und, entsprechend, der Wert 0.0 dann, wenn die gesamte Schicht am Klebband haften bleibt, so ergaben sich, nur beispielsweise bei der Auswertung der Substrate an Beispiel 6, eine Haftung von 1.0 sowohl bei der 128 nm dicken Kupferschicht wie auch der 256 nm dicken Kupferschicht an den PMMA-Substraten. Dies unabhängig davon, ob nach (a) oder (b) oder (c) vorbehandelt wurde. Bei allen Beschichtungsprozessen war die erfindungsgemäss geforderte Ionenenergie eingehalten worden.

Ohne vorangehende erfindungsgemässe Vorbehandlung schwankten die Haftungswerte bei der 128 nm dicken Schicht zwischen 0,2 und 0,7, bei der 256 nm dicken Schicht zwischen 0,0 und 0,7, unabhängig davon, ob die Substrate zusätzlich der Nassreinigung unterworfen worden waren.

Die erfindungsgemässe Vorbehandlung der Kunststoffkörper ergibt, wie erwähnt wurde, vorzügliche Resultate u.a. bei Aluminium-, Kupfer-, Silber-, Silizium-, Germanium-Beschichtungen, weiter bei Beschichtungen mit Verbindungshalbleitern (3-5, 2-6), mit Metalloxiden sowie -nitriden.

Die Ionenenergie des Plasmas zum Einhalt der geforderten maximalen Energien lässt sich mit Hilfe von Plasmamonitoren oder durch Ermittlung der Potentialdifferenz zwischen Plasmapotential und Substratpotential bestimmen.

## Patentansprüche

1. Verfahren zur Herstellung beschichteter Kunststoffkörper, bei dem, vor der Beschichtung, die zu beschichtende Oberfläche einer Vorbehandlung in einer angeregten Gasatmosphäre unterworfen wird, und die Oberfläche danach beschichtet wird, wobei die Gasatmosphäre überwiegend aus einem Edelgas und Stickstoff und/oder Wasserstoff gebildet wird und die Ionenenergie in der Gasatmosphäre und im Bereich der zu beschichtenden Oberfläche höchstens 50 eV ist.

2. Verfahren nach Anspruch 1, **dadurch gekennzeichnet, dass** die Ionenenergie zu höchstens 20 eV, vorzugsweise zu höchsten 10 eV gewählt wird.

3. Verfahren nach einem der Ansprüche 1 oder 2, **dadurch gekennzeichnet, dass** die Gasatmosphäre mittels einer Plasmaentladung oder mittels UV-Strahlung angeregt wird.

4. Verfahren nach Anspruch 3, **dadurch gekennzeichnet, dass** die Plasmaentladung als Mikrowellen- oder ECR-Entladung oder als Hf- oder getaktete DC-Entladung ausgebildet wird, vorzugsweise aber als Niederspannungsentladung, oder dass, gleichermassen bevorzugt, die Anregung mittels UV-Strahlung mit H- und N-Linien erzeugt wird.

5. Verfahren nach einem der Ansprüche 1 bis 4, **dadurch gekennzeichnet, dass** als Edelgas Argon eingesetzt wird.

6. Verfahren nach einem der Ansprüche 1 bis 5, **dadurch gekennzeichnet, dass** die vorbehandelte Oberfläche an Umgebungsatmosphäre gelagert wird und erst darnach beschichtet wird.

7. Verfahren nach einem der Ansprüche 1 bis 6, **dadurch gekennzeichnet, dass** die Beschichtung durch einen Vakuumbeschichtungsprozess erfolgt.

8. Verfahren nach Anspruch 7, **dadurch gekennzeichnet, dass** die Beschichtung durch Plasmapolymerisation, ein reaktives oder nicht reaktives PVD-Verfahren oder ein PECVD-Verfahren erfolgt.

9. Verfahren nach Anspruch 7, **dadurch gekennzeichnet, dass** die Beschichtung durch reaktives oder nicht reaktives Sputtern erfolgt, bevorzugterweise reaktives oder nicht reaktives Magnetronsputtern oder durch reaktives oder nicht reaktives Bedampfen.

10. Verfahren nach einem der Ansprüche 1 bis 9, **dadurch gekennzeichnet, dass** die zu beschichtende Oberfläche aus PMMA, BT oder FR4 besteht.

11. Verfahren nach einem der Ansprüche 1 bis 10, **dadurch gekennzeichnet, dass** der Kunststoffkörper mit einem Halbleiter, einem Metall oder einer Metallverbindung beschichtet wird.

12. Verwendung des Verfahrens nach einem der Ansprüche 1 bis 11 für die Herstellung von optischen Speicherplatten, von optischen Bauelementen, von Leiterplatten oder Teilen für die Halbleiterfertigung.

## Claims

1. Method of manufacturing coated plastic bodies in which, before coating, the surface to be coated is subject to pre-treatment in an excited gas atmosphere and the surface is then coated, wherein the gas atmosphere is formed mainly from a noble gas and nitrogen and/or hydrogen and the ion energy in the gas atmosphere and in the area of the surface to be coated is maximum 50 eV.

2. Method according to claim 1, **characterised in that** the ion energy is selected as maximum 20 eV, preferably maximum 10 eV.

3. Method according to one of claims 1 or 2, **characterised in that** the gas atmosphere is excited by means of a plasma discharge or by means of UV radiation.

4. Method according to claim 3, **characterised in that** the plasma discharge is formed as a microwave or ECR discharge, or as an Hf or switched DC discharge, preferably however as a low voltage discharge, or that equally preferably the excitation is generated by means of UV radiation with H and N lines.

5. Method according to any of claims 1 to 4, **characterised in** the noble gas used is argon.

6. Method according to any of claims 1 to 5, **characterised in that** the pre-treated surface is stored in ambient atmosphere and only thereafter coated.

7. Method according to any of claims 1 to 6, **characterised in that** the coating is applied by a vacuum coating process.

8. Method according to claim 7, **characterised in that** the coating is applied by plasma polymerisation, a reactive or non-reactive PVD method or a PECVD method.

9. Method according to claim 7, **characterised in that** the coating is applied by reactive or non-reactive sputtering, preferably reactive or non-reactive magnetron sputtering or by reactive or non-reactive vapour deposition.

10. Method according to any of claims 1 to 9, **characterised in that** the surface to be coated comprises PMMA, BT or FR4.

11. Method according to any of claims 1 to 10, **characterised in that** the plastic body is coated with a semiconductor, a metal or a metal compound.

12. Use of the method according to any of claims 1 to 11 for manufacturing optical memory disks, optical components, circuit boards or parts for semiconductor production.

## Revendications

1. Procédé pour fabriquer des corps en matière plastique revêtus, selon lequel avant l'application du revêtement la surface à revêtir est soumise à un traitement préalable dans une atmosphère gazeuse excitée, et la surface est ensuite revêtue, l'atmosphère gazeuse étant formée principalement d'un gaz rare et d'azote et/ou d'hydrogène, et l'énergie ionique contenue dans l'atmosphère gazeuse et dans la zone de la surface à revêtir étant au maximum de 50 eV.

2. Procédé selon la revendication 1, **caractérisé en ce que** l'énergie ionique choisie est au maximum de 20 eV, de préférence au maximum de 10 eV.

3. Procédé selon l'une des revendications 1 ou 2, **caractérisé en ce que** l'atmosphère gazeuse est excitée à l'aide d'une décharge de plasma ou à l'aide d'un rayonnement ultraviolet.

4. Procédé selon la revendication 3, **caractérisé en ce que** la décharge de plasma est conçue comme une décharge de micro-ondes ou une décharge ECR (résonance électronique cyclotronique) ou comme une décharge hf ou à courant continu commutée, mais de préférence comme une décharge basse tension, ou **en ce que**, également de préférence, l'excitation est produite à l'aide d'un rayonnement ultraviolet avec des lignes H et des lignes N.

5. Procédé selon l'une des revendications 1 à 4, **caractérisé en ce qu'**on utilise comme gaz rare de l'argon.

6. Procédé selon l'une des revendications 1 ou 5, **caractérisé en ce que** la surface traitée préalablement est stockée dans une atmosphère ambiante et n'est revêtue qu'après.

7. Procédé selon l'une des revendications 1 ou 6, **caractérisé en ce que** l'application du revêtement se fait à l'aide d'un procédé d'application de revêtement sous vide.

8. Procédé selon la revendication 7, **caractérisé en ce que** l'application du revêtement se fait par polymérisation de plasma, par dépôt physique en phase vapeur réactif ou non réactif ou par dépôt chimique en phase vapeur avec utilisation d'un plasma.

9. Procédé selon la revendication 7, **caractérisé en ce que** l'application du revêtement se fait par pulvérisation cathodique réactive ou non réactive, de préférence par pulvérisation cathodique par magnétron réactive ou non réactive ou par vaporisation réactive ou non réactive.

10. Procédé selon l'une des revendications 1 ou 9, **caractérisé en ce que** la surface à revêtir se compose de PMMA, de BT ou de FR4.

11. Procédé selon l'une des revendications 1 ou 10, **caractérisé en ce que** le corps en matière plastique est revêtu d'un semi-conducteur, d'un métal ou d'un composé métallique.

12. Utilisation du procédé selon l'une des revendications 1 ou 11 pour fabriquer des disques optiques, des composants optiques, des cartes imprimées ou des éléments pour la fabrication de semi-conducteurs.
